(19) Europäisches Patentamt
European Patent Office
Office européen des brevets

(11) Publication number: 0 137 512 B1

(12) # EUROPEAN PATENT SPECIFICATION

(45) Date of publication of patent specification: 16.01.91

(51) Int. Cl.$^5$: H 01 B 3/02 // H01L21/314

(21) Application number: 84112305.2

(22) Date of filing: 12.10.84

(54) **Solar cell.**

(30) Priority: 13.10.83 JP 192188/83

(43) Date of publication of application:
17.04.85 Bulletin 85/16

(45) Publication of the grant of the patent:
16.01.91 Bulletin 91/03

(84) Designated Contracting States:
DE FR GB IT NL

(56) References cited:
GB-A-1 566 072

PATENT ABSTRACTS OF JAPAN, vol. 8, no. 77 (C-218)1514r, 10th April 1984; & JP-A-59 3017 (SHARP K.K.) 09-01-1984

(73) Proprietor: KANEGAFUCHI KAGAKU KOGYO KABUSHIKI KAISHA
2-4 Nakanoshima 3-chome
Kita-ku Osaka-shi Osaka-fu (JP)

(72) Inventor: Nishimura, Kunio
Bukkoji-dori Nishinotoin-nishiiru Tokusayama-cho
Shimogyo-ku Kyoto-shi Kyoto-fu (JP)
Inventor: Nakayama, Takehisa
31-17, Shioya-cho 6-chome
Tarumi-ku Kobe-shi Hoyogo-ken (JP)
Inventor: Tsuge, Kazunori
9-30-1220, Maikodai 2-chome
Tarumi-ku Kobe-shi Hoyogo-ken (JP)
Inventor: Tawada, Yoshihisa
14-39, Oikemiyamadai Kita-ku
Kobe-shi Hoyogo-ken (JP)

(74) Representative: Türk, Gille, Hrabal
Brucknerstrasse 20
D-4000 Düsseldorf 13 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 137 512 B1

Courier Press, Leamington Spa, England.

**Description**

The present invention relates to a solar cell having on an electrically insulating layer comprising a non-monocrystalline silicon substance, which is deposited on a substrate by means of a plasma CVD method or a spatter method.

Hitherto, for the production of solar cells there has been used a substrate in the form of a light transmitting board coated with a transparent electrically conductive film such as ITO/glass or $SnO_2$/glass; a metal board made of stainless steel, iron, aluminum, nickel, brass, copper, zinc or an alloy thereof; a metal board treated with other metal and the like.

When an electrically conductive board such as a metal board is used as a substrate for a solar cell, since a plurality of cells are formed in a pattern on a single substrate and are connected in series, it is required that the substrate is electrically insulated from the solar cell electrode on the board side. For this reason, an insulation layer is formed on the substrate. The insulation material used for formation of said insulation layer must be heat resistant since the substrate must be subjected to a heat treatment at a temperature of 20° to 350°C in the preparation process of a solar cell. Therefore, a heat-resistant organic polymer such as polyimide resin is usually applied to the substrate by such a method as spin coating or dipping and subjected to a heat treatment for curing and degassing.

For preparing a solar cell, in general, the higher the semiconductor layer forming temperature, the higher the quality of the resulting solar cell. However, when a solar cell is produced by using a substrate having the insulation layer made of polyimide resin, the semiconductor layer forming temperature can raise only up to 250°C, such a temperature being insufficient for obtaining a solar cell of high quality. Moreover, condensation occurs in the insulation layer during heating to release $H_2O$ or to discharge impurities, which lowers the characteristics of the solar cell. There has been proposed a process for forming an electric insulation layer by using amorphous silicon. In such a case, however, the dielectric breakdown voltage is low i.e. only 20 to 30 V/μm, and thus the deposit of the amorphous silicon must be considerably thick.

The object of the present invention is to provide a solar cell having on an electrically insulating layer deposited on a substrate which has an improved heat resistance and can eliminate the complex heat treatment required for the formation of an insulating layer made of polyimide resin which degrades characteristics of the product.

According to the present invention, there is provided a solar cell having on an electrically insulating thin layer comprising a non-monocrystalline silicon substance, being deposited on a metal board by means of plasma CVD method or spatter method, and having a carbon content of not less than 10% (% by atom).

The insulating layer has an excellent heat resistance, and does not require a complex heat treatment, and can be made thinner.

It is known to provide a semi-conductor device on the surface thereof with an electrically insulating film layer formed of an amorphous silicon carbide, said film layer including at least one element selected from the group consisting of nitrogene, oxygene and chloride (GB—A—1 566 072). This electrically insulating film layer serves as protective film on the surface of the semi-conductor device but does not serve as substrate for producing semi-conductors thereon.

In the drawings,

Fig. 1 is a schematic perspective view of an embodiment according to the present invention; and

Fig. 2 is a schematic sectional view of an apparatus to be used in producing solar cells according to the present invention.

Nonrestrictive examples of the substrates used in the present invention are, for instance, an electrically conductive board such as a metal board of 0.03 to 1 mm in thickness made of stainless steel, iron, aluminum, nickel, brass, copper, zinc, or the like.

The insulating layer of the present invention is formed on the substrate by the usual plasma CVD method or spatter method (spatter vapor deposition method).

It is preferable that the insulating layer formed by such method contains carbon atoms of not less than 10%. If the carbon content is less than 10%, the dielectric breakdown voltage decreases to 50 V/μm or less, which means insufficiency in point of insulating performance. If the carbon content is 30% or more, the dielectric breakdown voltage of the insulation layer further increases to 100 V/μm or more, which is preferable for a semiconductor device produced by glow discharge.

From the standpoints of relieving stress in the film and imparting structural flexibility thereto, it is preferable that the insulation layer of the present invention is made of an amorphous substance represented by the formula:

$$Si_{(1-x-y)}C_xX_y:H$$

(wherein X is at least one member selected from the group consisting of N, O, P, Cl, Br and Ge; $1 \geqq x \geqq 0.1$; $0.9 \geqq y \geqq 0$; and $1 \geqq x+y \geqq 0.1$). However, the non-monocrystalline substance of the insulation layer of the present invention is not limited thereto.

Typical examples of the amorphous substance represented by the general formula are, for instance,

$$C:H,\ Si_{(1-x)}C_x:H$$

(wherein x is as defined above),

$Si_{(1-x-y)}C_xN_y$:H

(wherein x and y are as defined above),

$Si_{(1-x-y)}C_xF_y$:H

(wherein x and y are as defined above), and the like.

The insulation layer of the present invention may or may not contain hydrogen atom. Further, the insulation layer is preferably not doped, but it may be doped with a small amount of boron, phosphorus, or the like.

The insulation layer can be formed from a gas mixture by the plasma CVD method or spatter method. The gas mixture preferably comprises a gas of a silicon-containing compound and a gas of a carbon-containing compound, and, if necessary, a diluent gas such as hydrogen gas and an inert gas. Examples of the silicon-containing compounds are, for instance, silane, polysilane such as disilane or trisilane, organosilicon derivative such as trimethylsilane or halogenated derivative thereof, a mixture thereof, and the like. Examples of the carbon-containing compounds are, for instance, a saturated or unsaturated hydrocarbon such as methane, ethylene, acetylene or propane, a halogenated derivative thereof, an admixture thereof, and the like. The carbon-containing compound can be admixed so that the insulation layer formed contains carbon atoms of not less than 10%.

Though not specifically limited, the thickness of the insulation layer is preferably about 0.5 to 100 µm, more preferably about 1 to 10 µm. If the thickness of the insulation layer is about 0.5 to 100 µm, there is obtained a dielectric breakdown voltage of 50 V/µm or above. If the thickness is not more than 0.5 µm, pinholes tend to increase, while if it exceeds 100 µm, peel-off tends to occur owing to internal stress. If the thickness is about 1 to 10 µm, there is obtained a dielectric breakdown voltage of about 100 to 1000 V/µm, pinholes decrease, and less peel-off takes place.

The insulating layer of the present invention is now described and explained with reference to the drawings.

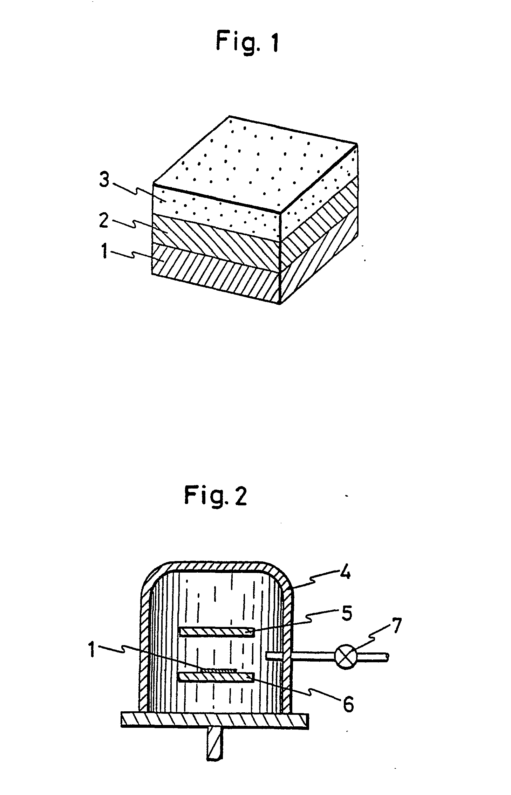

Referring to Fig. 1, an electric insulating layer 2 of the present invention is formed on a substrate 1, and then a metal film electrode 3 is formed thereon.

Fig. 2 is a schematic sectional view showing an embodiment of a vacuum apparatus for depositing the insulating layer on a substrate by the plasma CVD method or spatter method.

A process of deposition of the insulating layer of the present invention by the plasma CVD method with the apparatus shown in Fig. 2 is carried out, for example, by placing the substrate 1 on an electrode 6 and evacuating a vacuum container 4 once to $1\times10^{-4}$ to $10\times10^{-4}$ N/m$^2$ ($1\times10^{-6}$ to $10\times10^{-6}$ Torr). Thereafter, a valve 7 is opened to introduce a gas mixture. While maintaining a degree of vacuum of about 1 to 500 N/m$^2$ ($1\times10^{-2}$ to 5 Torr), a DC voltage or a high frequency voltage with 1 kHz to tens of MHz is applied between the electrodes 5 and 6 to establish a plasma state in the vacuum container 4. This state is maintained for minutes to hours, whereby there is formed on the substrate the insulation layer having a thickness of about 0.5 to 100 µm, a carbon content of not less than 10%, and a dielectric breakdown voltage of not less than 50 V/µm.

A process of deposition of the insulating layer of the present invention by the spatter method is carried out, for example, by placing the substrate 1 on the electrode 6 of the apparatus shown in Fig. 2 and evacuating the vacuum container 4 once to $1\times10^{-4}$ to $10\times10^{-4}$ N/m$^2$ ($1\times10^{-6}$ to $10\times10^{-6}$ Torr). Thereafter, a gas mixture of an inert gas such as argon gas or helium gas and hydrogen gas, a hydrocarbon gas or a silicon compound gas is fed through the valve 7 into the vacuum container 4. While maintaining a degree of vacuum of about $5\times10^{-4}$ to 10 N/m$^2$ ($5\times10^{-6}$ to $1\times10^{-1}$ Torr), a DC voltage or a high frequency voltage with 1 kHz to tens of MHz is applied between the electrode 5 having a target of SiC, graphite or silicon, and the electrode 6 on which the substrate 1 is placed so as to establish a plasma state in the vacuum container 4. This state is maintained for minutes or hours, whereby there is formed on the substrate 1 the insulating layer 2 having a film thickness of 0.5 to 100 µm, a carbon content of not less than 10%, and a dielectric breakdown voltage of not less than 50 V/µm. It is preferable that the applied voltage for establishing the plasma state is about 1 to 3 kV, the current is 100 to 300 mA, and the power is about 100 to 300 W.

By forming a metal layer on the insulating layer by means of the vacuum evaporation method or the spatter method, the substrate with the insulation layer and the metal electrode shown in Fig. 1 can be prepared. The metal layer has an appropriate electric conductivity and a thickness of about 50 to 1 µm. Materials of the metal layer are, for instance, aluminum, molybdenum, stainless steel, antimony, chromium, nickrome, and the like.

The insulating layer of the present invention does not need to undergo a heat treatment during production as it was needed in the case of use of polyimide resin, and its heat resistance is higher than when polyimide resin is used. Further, since there is no influence from degassing by heating during the production of a solar cell, semiconductor layer formation can be effected at a high temperature and the performance of a solar cell obtained can be improved. Furthermore, as compared with the case where polyimide resin is formed by the spin coating method or dipping method, the formation of the insulating layer by the plasma CVD method or spatter method ensures uniform formation of the layer, so that the yield is improved. The insulating layer of the present invention has a dielectric breakdown voltage of 50 V/µm or above, preferably a dielectric breakdown voltage of 100 V/µm or above.

The present invention is more particularly described and explained by means of the following Example.

Example

This example was carried out by the plasma CVD method by using an apparatus similar to the one shown in Fig. 2.

A stainless 304 sheet having a thickness of 0.2 mm was employed as the substrate 1 and was placed on the electrode 6. The distance between the electrodes 5 and 6 was 20 mm, and the substrate was heated so that its surface temperature was 250°C. After the vacuum container 4 was evacuated to $1\times10^{-4}$ N/m$^2$ ($1\times10^{-6}$ Torr), a gas mixture of 2 sccm (standard cubic centimeter) of silane and 180 sccm of methame diluted with hydrogen to 10% by volume was introduced through the valve 7, and the degree of vacuum was maintained at 150 N/m$^2$ (1.5 Torr). In this state, a high frequency voltage (30 W, 13.56 MHz) was applied between the electrodes 5 and 6 to establish a plasma state in the vacuum container, and the state was maintained for 3 hours, whereby an insulating layer 2 was formed.

The insulating layer obtained had a film thickness of 2 µm and an optical inhibition band width of Eg (Opt) 2.6 eV. The carbon content of the insulation layer measured by the Auger electron spectroanalysis was 45%.

Thereafter, chromium was deposited as the metal electrode 3 on the surface of the insulating layer 2 by the electron beam vapor deposition method so that its thickness was 100 µm (1000 Å).

Voltage was applied between the substrate 1 and the metal electrode 3. The dielectric breakdown voltage was found to be about 300 V/µm.

In addition to the ingredients and the method used in the Example, other ingredients and method can be used in the Example as set forth in the specification to obtain substantially the same results.

**Claims**

1. Solar cell, which is produced on a substrate comprising a metal board (1) and an electrically insulating heat resistant layer (2) formed on said metal board on which insulating layer a plurality of solar cells (3), which are connected in series, is formed, characterized in that said electrically insulating layer (2) is a thin layer comprising a non-monocrystalline silicon substance being deposited on said metal board (1) by means of plasma CVD method or spatter method, and having a carbon content of not less than 10% by atom.

2. Solar cell as claimed in Claim 1, wherein the carbon content of the electrically insulating layer (2) is not less than 30% by atom.

3. Solar cells as claimed in Claim 1 or 2, wherein the electrically insulating layer (2) has a dielectric breakdown voltage of not less than 50 V/µm.

4. Solar cell as claimed in Claim 1 or 2, wherein the electrically insulating layer (2) has a dielectric breakdown voltage of not less than 100 V/µm.

5. Solar cell as claimed in one of Claims 1 to 4, wherein the electrically insulating layer (2) has a thickness of 0.5 to 100 µm.

6. Solar cell as claimed in Claim 5, wherein the electrically insulating layer (2) has a thickness of 1 to 10 µm.

7. Solar cell as claimed in Claim 1, wherein the non-monocrystalline substance of the electrically insulating thin layer (2) is an amorphous silicon substance of the formula:

$$Si_{(1-x-y)}C_xX_y{:}H$$

wherein X is at least one member selected from the group consisting of N, O, F, Cl, Br and Ge, $1\geqq X\geqq 0.1$, $0.9\geqq y\geqq 0$; and $1\geqq x+y\geqq 0.1$.

**Patentansprüche**

1. Solarzelle, die auf ein Substrat aufgebracht wird, das eine Metallplatte (1) und eine auf die Metallplatte aufgebrachte elektrisch isolierende Schicht (2) aufweist, auf der eine Vielzahl von in Reihe geschalteten Solarzellen befestigt ist, dadurch gekennzeichnet, daß die elektrisch isolierende Schicht (2) eine dünne Schicht ist, die eine nicht monokristalline Silikonmasse enthält, die durch das Plasma CVD-Verfahren oder mit der Spritzpistole aufgetragen ist und die einen Kohlenstoffgehalt von mindestens 10 Atom % hat.

2. Solarzelle nach Anspruch 1, dadurch gekennzeichnet, daß der Kohlenstoffgehalt der elektrischen Isolierschicht (2) nicht weniger als 30 Atom % beträgt.

3. Solarzelle nach einem der Ansprüche 1 oder 2, dadurch gekennzeichnet, daß die elektrische Isolierschicht (2) eine dielektrische Durchschlagspannung von mindestens 50 V/µm hat.

4. Solarzelle nach einem der Ansprüche 1 oder 2, dadurch gekennzeichnet, daß die elektrische Isolierschicht (2) eine dielektrische Durchschlagspannung von mindestens 100 V/µm hat.

5. Solarzelle nach einem der Ansprüche 1 bis 4, dadurch gekennzeichnet, daß die elektrische Isolierschicht (2) eine Dicke von 0,5 bis 100 µm hat.

6. Solarzelle nach Anspruch 5, dadurch gekennzeichnet, daß die elektrische Isolierschicht (2) eine Dicke von 1 bis 10 µm hat.

7. Solarzelle nach Anspruch 1, dadurch gekennzeichnet, daß die nicht monokristalline Masse der dünnen elektrischen Isolierschicht (2) eine amorphe Silikonmasse ist, die folgende Formel hat:

$$Si_{(1-x-y)}C_xX_y{:}H$$

darin ist X mindestens eine Verbindung aus der Gruppe bestehend aus N, O, F, Cl, Br und Ge, $1\geqq X\geqq 0{,}1$, $0{,}9\geqq y\geqq 0$; und $1\geqq x+y\geqq 0{,}1$.

**Revendications**

1. Cellule solaire qui est produite sur un substrat comprenant une plaque métallique (1) et une couche résistante à la chaleur électriquement isolante (2) formée sur ladite plaque métallique, sur laquelle couche d'isolement sont formées une pluralité de cellules solaires (3) qui sont reliées en série, caractérisé en ce que ladite couche électriquement isolante (2) est une couche mince comprenant une substance de silicium non monocristallin déposée sur ladite plaque métallique (1) au moyen d'un procédé en phase vapeur par plasma ou d'un procédé de projection, et présentant une teneur en carbone qui n'est pas inférieure à 10% en atome.

2. Cellule solaire selon la revendication 1, dans laquelle la teneur en carbone de la couche électriquement isolante (2) n'est pas inférieure à 30% en atome.

3. Cellule solaire selon la revendication 1 ou 2, dans laquelle la couche électriquement isolante (2) présente une tension de rupture diélectrique qui n'est pas inférieure à 50 V/µm.

4. Cellule solaire selon la revendication 1 ou 2, dans laquelle la couche électriquement isolante (2) présente une tension de rupture diélectrique qui n'est pas inférieure à 100 V/µm.

5. Cellule solaire selon l'une quelconque des revendications 1 à 4, dans laquelle la couche électriquement isolante (2) présente une épaisseur de 0,5 à 100 µm.

6. Cellulose solaire selon la revendication 5, dans laquelle la couche électriquement isolante (2) présente une épaisseur de 1 à 10 µm.

7. Cellule solaire selon la revendication 1, dans laquelle la substance non monocristalline de la couche mince électriquement isolante (2) est une substance de silicium amorphe de la formule:

$$Si_{(1-x-y)}C_xX_y{:}H$$

dans laquelle X est au moins un élément sélectionné dans le groupe constitué de N, O, F, Cl, Br et Ge, $1 \geqq x \geqq 0{,}1$, $0{,}9 \geqq y \geqq 0$; et $1 \geqq x+y \geqq 0{,}1$.

Fig. 1

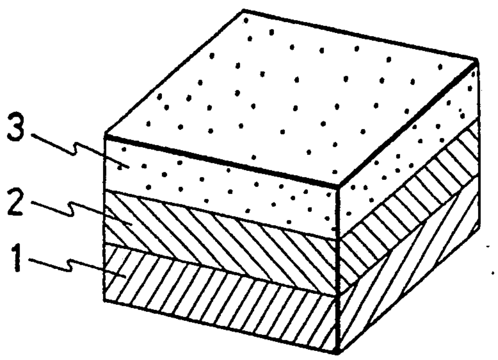


Fig. 2